# EUROPÄISCHE PATENTSCHRIFT

(11) **EP 1 933 380 B1**
(45) Veröffentlichungstag und Bekanntmachung des Hinweises auf die Patenterteilung: **24.02.2010**
(21) Anmeldenummer: 07024105.4
(22) Anmeldetag: 12.12.2007
(51) Int. Cl.: H01L 25/07, H01L 23/48, H01R 13/24

(54) **Leistungshalbleitermodul mit Kontaktfedern**
Power semiconductor module with contact springs
Module semi-conducteur de puissance doté de ressorts de contact

(30) Priorität: 13.12.2006 DE 102006058694
(43) Veröffentlichungstag der Anmeldung: 18.06.2008
(73) Patentinhaber: SEMIKRON Elektronik GmbH & Co. KG, 90431 Nürnberg (DE)
(72) Erfinder: Popp, Rainer, 91580 Petersaurach (DE); Lederer, Marco, 90453 Nürnberg (DE)

(56) Entgegenhaltungen:
- EP-A- 1 648 029
- DE-A1-102004 025 609
- DE-A1-102005 039 946
- DE-A1-102006 006 421
- DE-C1- 10 231 219
- GB-A- 2 042 803

## Beschreibung

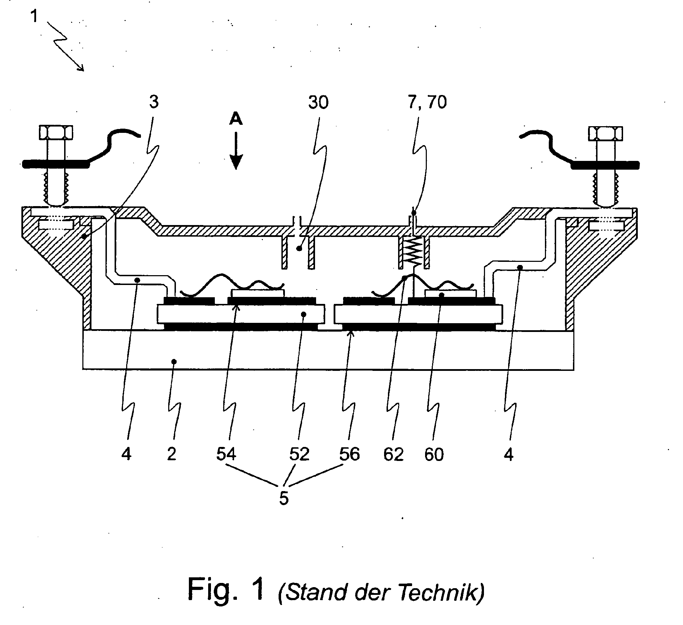

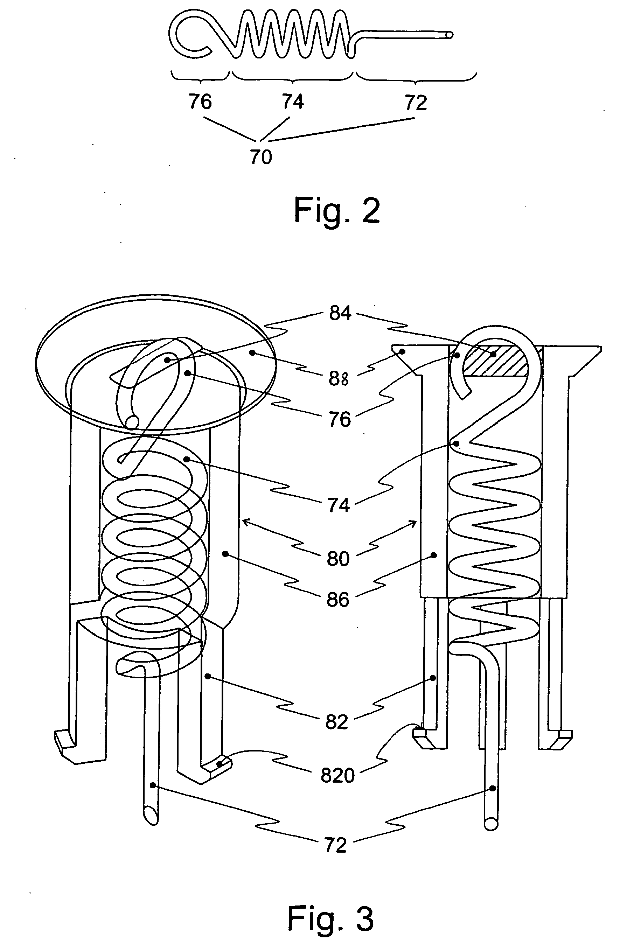

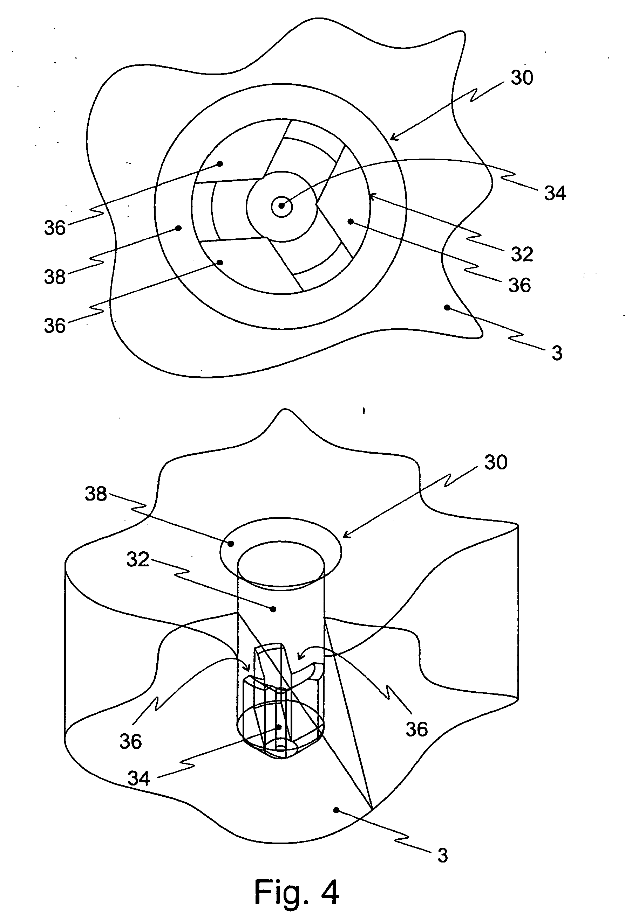

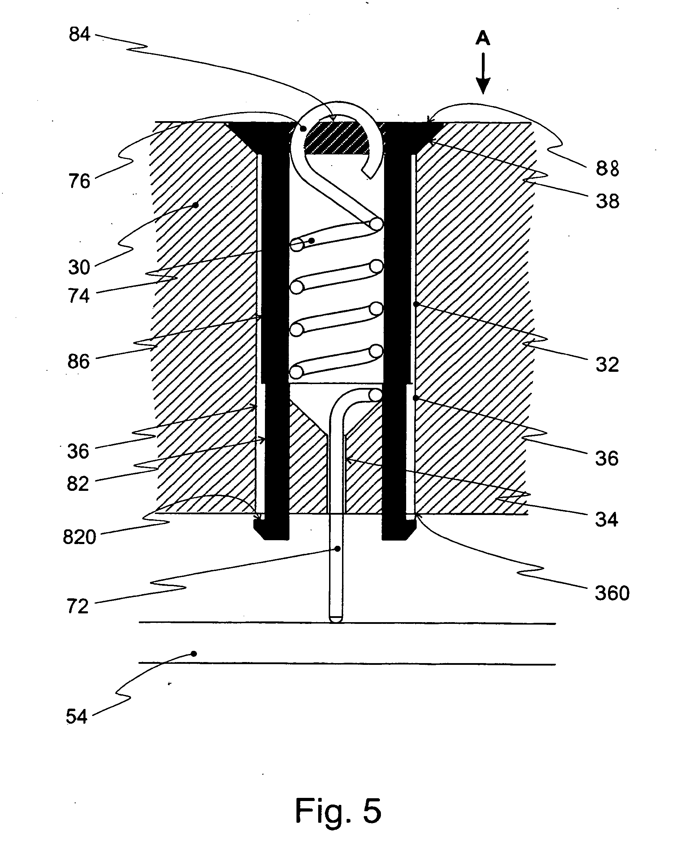

[1] Die Erfindung beschreibt ein Leistungshalbleitermodul in Druckkontaktausführung mit mindestens einem als Kontaktfeder ausgebildeten Anschlusselement. Einen Ausgangspunkt der Erfindung bilden Leistungshalbleitermodule wie sie beispielhaft aus der DE 197 19 703 A1 bekannt sind.
[2] Derartige Leistungshalbleitermodule bestehen nach dem Stand der Technik aus einem Gehäuse mit mindestens einem darin angeordneten elektrisch isolierenden Substrat vorzugsweise zur direkten Montage auf einem Kühlbauteil. Das Substrat seinerseits besteht aus einem Isolierstoffkörper mit einer Mehrzahl darauf befindlicher gegeneinander isolierter metallischer Verbindungsbahnen und hierauf befindlichen und mit diesen Verbindungsbahnen schaltungsgerecht verbundenen Leistungshalbleiterbauelementen. Weiterhin weisen die bekannten Leistungshalbleitermodule Anschlusselemente für externe Last- und Hilfsanschlüsse sowie im Inneren angeordnete Verbindungselemente auf. Diese Verbindungselemente für schaltungsgerechte Verbindungen im Inneren des Leistungshalbleitermoduls sind meist als Drahtbondverbindungen ausgebildet.
[3] Ebenfalls bekannt sind druckkontaktierte Leistungshalbleitermodule, wie sie aus der DE 42 37 632 A1 bekannt sind. In dieser Druckschrift weist die Druckeinrichtung ein stabiles, vorzugsweise metallisches, Druckelement zum Druckaufbau, ein elastisches Kissenelement zur Druck Speicherung und ein Brückenelement zur Druckeinleitung auf gesonderte Bereiche der Substratoberfläche auf. Das Brückenelement ist vorzugsweise ausgestaltet als ein Kunststoffformkörper mit einer dem Kissenelement zugewandten Fläche, von der eine Vielzahl von Druckfingern in Richtung der Substratoberfläche ausgehen.
[4] Mittels einer derartigen Druckeinrichtung wird das Substrat auf ein Kühlbauteil gedrückt und somit der Wärmeübergang zwischen dem Substrat und dem Kühlbauteil dauerhaft sicher hergestellt. Das elastische Kissenelement dient hierbei der Aufrechterhaltung konstanter Druckverhältnisse bei unterschiedlichen thermischen Belastungen und über den gesamten Lebenszyklus des Leistungshalbleitermoduls.
[5] Aus der DE 10 2004 025 609 A1 ist ein Leistungshalbleitermodul mit einer Grundplatte und als Kontaktfedern ausgebildeten Hilfsanschlusselementen bekannt. Gemäß dieser Druckschrift werden die Kontaktfedern zur sicheren elektrischen Kontaktierung mittels eines Deckels mit Druck beaufschlagt. Hierbei sind die Kontaktfedern in einer nicht detailliert offen gelegten Halterung des Gehäuses angeordnet.
   EP-A-1 648 029 beschreibt eine Kontakteinrichtung bestehend aus einem Hohlkörper und einem darin angeordneten Federelement, die für den Steueranschluss von Leistungshalbleitermodulen eingesetzt wird.
[6] Aus der nicht vorveröffentlichten DE 10 2006 006 421 ist ein Leistungshalbleitermodul mit mindestens einem Anschlusselement, das als eine Kontaktfeder mit einer ersten Kontakteinrichtung, einem federnden Abschnitt und einer zweiten Kontakteinrichtung ausgebildet ist, bekannt. Hierbei weist ein erster Kunststoffformkörper einen senkrecht zum Substrat angeordneten Schacht zur Aufnahme eines Anschlusselements auf. Dieser Schacht weist seinerseits eine seitliche Ausnehmung zur verdrehsicheren Anordnung des Anschlusselements und eine Aussparung für einen zugeordneten Teilkörper eines zweiten Kunststoffformkörper auf, wobei dieser Teilkörper ebenfalls eine seitliche Ausnehmung und auf der dem Substrat abgewandten Seite eine Ausnehmung für die erste Kontakteinrichtung des Anschlusselements aufweist und diese hier hindurch reicht.
[7] Der Erfindung liegt die Aufgabe zugrunde ein Leistungshalbleitermodul vorzustellen, wobei die Anschlusselemente federnd ausgebildet sind, gegen Herausfallen gesichert sind und das Leistungshalbleitermodul einer einfachen Herstellung zugänglich ist.
[8] Die Aufgabe wird erfindungsgemäß gelöst, durch die Maßnahmen der Merkmale des Anspruchs 1. Bevorzugte Ausführungsformen sind in den Unteransprüchen beschrieben.
[9] Der erfinderische Gedanke geht aus von einem Leistungshalbleitermodul der oben genannten Art mit einem Gehäuse und einem Substrat mit mindestens einer metallischen Leiterbahn. Von mindestens einer Leiterbahn oder mindestens einer Kontaktfläche eines auf einer Leiterbahn angeordneten Leistungshalbleiterbauelements führt mindestens ein Anschlusselement aus dem Gehäuse heraus.
[10] Mindestens eines dieser Anschlusselemente ist als Kontaktfeder mit einer ersten Kontakteinrichtung, einem federnden Abschnitt und einer zweiten Kontakteinrichtung ausgebildet. Das Gehäuse weist eine Ausnehmung zur Aufnahme der Kontaktfeder auf, die gebildet wird aus einer Mehrzahl von Teilausnehmungen. In der ersten Teilausnehmung des Gehäuses ist ein Hohlkörper angeordnet, in dem wiederum wesentliche Teile der Kontaktfeder angeordnet und gegen Herausfallen in Richtung der zweiten Kontakteinrichtung der Kontaktfeder gesichert sind. Weiterhin weist dieser Hohlkörper eine Schnapp- Rastverbindung mit dem Gehäuse auf. Ebenso weist das Gehäuse eine zweite Teilausnehmung zur Durchführung der ersten Kontakteinrichtung der Kontaktfeder auf.
[11] Die erfinderische Lösung wird an Hand der Ausführungsbeispiele der Fig. 1 bis 5 weiter erläutert.
[12] Fig. 1 zeigt ein Leistungshalbleitermodul mit Anschlusselementen nach dem Stand der Technik.
[13] Fig. 2 zeigt eine Ausgestaltung einer Kontaktfeder.
[14] Fig. 3 zeigt zwei Darstellungen einer Ausgestaltung eines Hohlkörpers mit darin angeordneter Kontaktfeder eines erfindungsgemäßen Leistungshalbleitermoduls.
[15] Fig. 4 zeigt zwei Darstellungen einer Ausnehmung eines erfindungsgemäßen Leistungshalbleitermoduls.
[16] Fig. 5 zeigt einen Schnitt durch einen Teil eines erfindungsgemäßen Leistungshalbleitermoduls.
[17] Fig. 1 zeigt ein Leistungshalbleitermodul (1) nach dem Stand der Technik. Das Leistungshalbleitermodul (1) weist eine Grundplatte (2) mit hierauf angeordneten Substraten (5), vorzugsweise ausgebildet als DCB (direct copper bonding) Substrate, auf. Das jeweilige Substrat (5) weist eine Isolierkeramik (52) mit beidseitigen Metallkaschierungen (54, 56) auf. Die Metallkaschierungen (54) im Inneren des Leistungshalbleitermoduls (1) bildet durch Strukturierung eine Mehrzahl von Leiterbahnen (54) zur Anordnung schaltungsgerecht mittels Drahtbondverbindungen (62) verbundener Leistungshalbleiterbauelement (60) auf und dient auch als Kontaktfläche für Anschlusselemente (4, 7).
[18] Dargestellt ist ein Leistungshalbleitermodul (1) mit der Grundplatte (2) und mit einem Gehäuse (3) welches eine Mehrzahl von Substraten (5) umschließt. Das Gehäuse weist eine Mehrzahl von Durchführungen bzw. Ausnehmungen (30) für Anschlusselemente (4, 7) zur externen Verbindung auf. Dargestellt sind hier Lastanschlusselemente (4) in Form flächiger Metallformkörper, sowie Hilfsanschlusselemente (7) in Form von Kontaktfedern (70).
[19] Diese Kontaktfedern (70) weisen eine erste Kontakteinrichtung zur Kontaktierung von Leiterbahnen oder auch nicht dargestellten von Kontaktflächen von Leistungshalbleiterbauelementen, einen federnden Abschnitt und eine zweite Kontakteinrichtung zur externen Verbindung auf (vgl. Fig. 2).
[20] Diese Darstellung zeigt eine beispielhafte Ausgestaltung eines Leistungshalbleitermodul (1), wobei die folgenden hierauf basierenden erfindungsgemäßen Ausgestaltungen auch für weitere Ausbildungen von Leistungshalbleitermodulen, beispielhaft ohne Grundplatte, mit weiteren Substratvarianten oder anderen Gehäuseausbildungen geeignet sind. Auch kann es speziell bei Leistungshalbleitermodulen mit geringer Leistung bevorzugt sein nicht nur wie hier dargestellt die Hilfsanschlüsse sondern auch die Lastanschlüsse mit Kontaktfedern auszubilden.
[21] Fig. 2 zeigt eine Ausgestaltung einer Kontaktfeder (70). Diese Kontaktfeder (70) weist eine erste stiftartig geformte Kontakteinrichtung (72) auf, die vorzugsweise der Kontaktierung einer Leiterbahn (54) des Substrats (5) dient. Der federnde mittlere Abschnitt (74) ist als Schraubenfeder ausgebildet. Die zweite Kontakteinrichtung (76) weist einen gebogenen Abschnitt zur externen Kontaktierung des Leistungshalbleitermoduls (1) vorzugsweise mit einer Leiterplatte auf.
[22] Fig. 3 zeigt zwei Darstellungen einer Ausgestaltung eines Hohlkörpers (80) mit darin angeordneter Kontaktfeder (70) eines erfindungsgemäßen Leistungshalbleitermoduls (1). Auf der linken Seite ist hier ein vereinfachtes dreidimensionales Gittermodel und rechts eine Schnittdarstellung gezeigt. Der Hohlkörper (80) weist hierbei einen zylindrischen Grundkörper (86) auf. In diesem Grundkörper (86) ist der federnde Abschnitt (74) der Kontaktfeder (70) angeordnet. An diesen als Schraubenfeder ausgebildeten Abschnitt (74) schließt sich in Richtung der Außenseite des Leistungshalbleitermoduls (1) der zweite federnde Abschnitt (76) an. Dieser ragt teilweise aus dem Hohlkörper (80) heraus um der externen Kontaktierung zu dienen. Hierzu weist der Hohlkörper (80) eine geschlossen Deckfläche mit einer schlitzförmigen Ausnehmung (84) auf, durch welche diese zweite Kontakteinrichtung (76) teilweise hindurch ragt. Durch diese schlitzförmige Ausgestaltung der Ausnehmung (84) ist gewährleistet, dass die Kontaktfeder (70) auf Grund des als Schraubenfeder ausgebildeten federnden Abschnittes (74) nicht aus dem Hohlkörper (80) in Richtung des Äußeren des Leistungshalbleitermoduls (1) herausfallen kann.
[23] Weiterhin weist der Hohlkörper (80) an seiner dem Inneren des Leistungshalbleitermodul (1) abgewandten Seite ein konusförmig ausgebildetes Anschlagmittel (88) zur Positionierung in dem zugeordneten Widerlager (38, vgl. Fig. 5) der Ausnehmung (30) des Gehäuses (3) auf.
[24] Zur weiteren Fixierung des Hohlkörpers (80) im Gehäuse (3) ist eine Schnapp-Rastverbindung (82, 820, 360) vorgesehen. Vorzugsweise ist diese gebildet durch eine Mehrzahl von Rastnasen (82) angeordnet an der dem Inneren des Leistungshalbleitermoduls (1) zugewandten Seite des Hohlkörpers (80). Die Rastflächen (820) der Rastnasen (82) finden ihr Widerlager (360) in Teilen bzw. Teilflächen (vgl. Fig. 5) der Innenseite des Gehäuses (3).
[25] Fig. 4 zeigt zwei Darstellungen einer Ausnehmung (30) in einem Gehäuse (3) eines erfindungsgemäßen Leistungshalbleitermoduls (1). Die obere Darstellung zeigt die Ausnehmung (30) des Gehäuses (3) zur Aufnahme des Hohlkörpers (80) aus Blickrichtung (A, vgl. Fig. 1 und 5). Die untere Darstellung zeigt ein vereinfachtes Drahtmodel in dreidimensionaler Ansicht.
[26] Dargestellt ist jeweils die erste zylinderförmige Teilausnehmung (32) mit dem in Richtung der Außenseite des Leistungshalbleitermoduls (1) anschließenden sich konisch öffnenden Widerlagers (38) für das Anschlagmittel (88) des Hohlkörpers (80). In Richtung der Innenseite des Leistungshalbleitermoduls (1) schließt sich eine zweite Teilausnehmung (34) zur Aufnahme der ersten Kontakteinrichtung (72) der Kontaktfeder (70) an. Diese zweite Teilausnehmung (34) fluchtet mit der ersten (32) wobei diese sich zumindest teilweise in konischem Verlauf in Richtung der zweiten (34) schließt.
[27] Konzentrisch um diese zweite Teilausnehmung (34) herum angeordnet sind weitere, hier drei, Teilausnehmungen (36) zur Aufnahme der Rastnasen (82) der Schnapp- Rastverbindung (82, 820, 360) zwischen dem Hohlkörper (80) und dem Gehäuse (3).
[28] Fig. 5 zeigt einen Teilschnitt durch ein erfindungsgemäßes Leistungshalbleitermodul (1). Dargestellt ist hier ein Teil des Gehäuses (3) mit einer Ausnehmung (30), die gebildet ist aus der ersten Teilausnehmung (32) mit im wesentlichen zylinderförmiger Form und an ihrem der Außenseite des Leistungshalbleitermoduls zugewandten Ende angeordnet ein Widerlager (38) für ein Anschlagmittel (88) des Hohlkörpers (80).
[29] Auf der dem Inneren des Leistungshalbleitermoduls (1) zugewandten Seite geht die erste Teilausnehmung (32) konusförmig in die zweite Teilausnehmung (34) über. Diese zweite Teilausnehmung (34) dient der Anordnung der ersten stiftartigen Kontakteinrichtung (72) der Kontaktfeder (70). Um diese zweite Teilausnehmung (34) sind konzentrisch eine Mehrzahl weiterer Teilausnehmungen (36) angeordnet. Diese weiteren Teilausnehmungen (36) dienen der Durchführung der Rastnasen (82) des Hohlkörpers (80).
[30] Der in der Ausnehmung (30) angeordnete Hohlkörper (80) weist einen zylinderförmigen Grundkörper (86) auf, wobei dieser an seiner dem Inneren des Leistungshalbleitermodul (1) abgewandten Seite ein Anschlagmittel (88) zur Positionierung in dem Widerlager (38) der Ausnehmung (30) des Gehäuses (3) aufweist. Ebenfalls an dieser Seite weist der Hohlkörper (80) eine geschlossen Fläche mit einer schlitzartigen Ausnehmung (84) zur Durchführung der zweiten Kontakteinrichtung (76) der Kontaktfeder (70) auf.
[31] An der dem Inneren des Leistungshalbleitermoduls (1) zugewandten Seite weist der Hohlkörper (80) eine Mehrzahl von Rastnasen (82) zur Ausbildung der Schnapp-Rastverbindung des Hohlkörpers (80) mit dem Gehäuse (3) auf. Die Rastnasen (82) weisen Rastflächen (820) zur Anordnung auf dem als Widerlager (360) wirkenden Teile der Innenseite des Gehäuses (3) auf.
[32] Die Kontaktfeder (70) ist mit ihrem federnden Abschnitt (74) im Inneren des Hohlkörpers (80) angeordnet. Die in Richtung des Inneren des Leistungshalbleitermoduls (1) hieran anschießende erste Kontakteinrichtung (72) ist stiftförmig ausgebildet und ragt durch die zweite Teilausnehmung (34) bis auf eine Kontaktfläche auf der Leiterbahn (54) des Leistungshalbleitermodul (1) oder auf eine Kontaktfläche eines Leistungshalbleiterbauelements (60) hinab und stellt somit eine elektrischen leitende Verbindung her.
[33] Die zweite Kontakteinrichtung (76) ragt teilweise durch die Ausnehmung (84) des Hohlkörper (80) in den Außenbereich des Leistungshalbleitermoduls (1) und dient dort der elektrischen Kontaktierung beispielhaft mit einer Leiterplatte.
[34] Durch die beschriebene Anordnung der Kontaktfeder (70) in dem Hohlkörper (80) und in der Ausnehmung (30) des Gehäuses (3) ist diese gegen Herausfallen sowohl bei der Montage des Gehäuse (3) auf dem Substrat (5), wie auch gegen Herausfallen aus dem fertig aufgebauten Leistungshalbleitermodul (1) gesichert.

## Patentansprüche

1. Leistungshalbleitermodul (1) mit einem Gehäuse (3), einem im Inneren des Gehäuses angeordneten Substrat (5) mit mindestens einer metallischen Leiterbahn (54), und mindestens einem von der Leiterbahn (54) oder einer Kontaktfläche eines auf einer Leiterbahn angeordneten Leistungshalbleiterbauelements (60) nach außen führenden Anschlusselement (4, 7)
wobei das mindestens eine Anschlusselement (4, 7) als Kontaktfeder (70) mit einer ersten Kontakteinrichtung (72) zur Kontalitierung einer Leiterbahn des Substrats oder einer Kontaktfläche des Leistungshalbleiterbauelements, einem federnden Abschnitt (74) und einer zweiten Kontakteinrichtung (76) zur externen Verbindung ausgebildet ist,
wobei in einer ersten Teilausnehmung (32) einer Ausnehmung (30) des Gehäuses (3) ein Hohlkörper (80) angeordnet ist, in dem wiederum der federnde Abschnitt (74) und ein Teil der zweiten Kontakteinrichtung (76) der Kontaktfeder (70) angeordnet und durch eine schlitzartige Ausnehmung (84) zur Durchführung der zweiten Kontakteinrichtung (76) der Kontaktfeder (70) gegen Herausfallen in Richtung des Änßeren des Leistungshalbleitermoduls (70) gesichert sind, wobei dieser Hohlkörper (80) eine Schnapp- Rastverbindung (82, 820, 360) mit dem Gehäuse (3) und einen Grundkörper (86) aufweist, wobei der Grundkörper an seiner dem Inneren des Leistungshalbleitermoduls (1) abgewandten Seite ein Anschlagmittel (88) zur Positionierung in einem Widerlager (38) der Ausnehmung (30) des Gehäuses (3) aufweist und wobei die Ausnehmung (30) eine zweite Teilausnehmung (34) zur Durchführung der ersten Kontakteinrichtung (72) der Kontaktfeder (70) aufweist.

2. Leistungshalbleitermodul nach Anspruch 1,
wobei der Grundkörper (86) zylindrisch ausgebildet ist.

3. Leistungshalbleitermodul nach Anspruch 1,
wobei die Schnapp- Rastverbindung (82, 820, 360) durch eine Mehrzahl von Rastnasen (82) des Hohlkörpers (80) gebildet ist, deren Widerlager (360) durch Teile der Innenseite des Gehäuses (3) gebildet werden.

4. Leistungshalbleitermodul nach Ansprüchen 2 und 3,
wobei die Ausnehmung (30) des Gehäuses (3) eine Mehrzahl weiterer Teilausnehmungen (36) zur Durchführung der Rastnasen (82) aufweist und diese weiteren Teilausnehmungen (36) konzentrisch um die zweite Teilausnehmung (34) angeordnet sind.

5. Leistungshalbleitermodul nach Anspruch 1,
wobei die der federnde Abschnitt (74) der Kontaktfeder (70) als Schraubenfeder ausgebildet ist.

6. Leistungshalbleitermodul nach Anspruch 2,
wobei die erste Teilausnehmung (32) konusförmig in die zweite Teilausnehmung (34) übergeht und beide zueinander fluchtend angeordnet sind.

## Claims

1. Power semiconductor module (1) with a housing (3) and a substrate (5) arranged in the inside of the housing, with
at least one metallic conductor track (54), and at least one connection element (4, 7) leading outwards from the conductor track (54) or a contact surface of a power semiconductor component (60) arranged on a conductor track
wherein the at least one connection element (4, 7) is constructed as a contact spring (70) with a first contact device (72) for contacting a conductor track of the substrate or a contact surface of the power semiconductor component, a resilient section (74) and a second contact device (76) for external connection,
wherein a hollow body (80) is arranged in a first part recess (32) of a recess (30) of the housing (3), in which hollow body (80) in turn the resilient section (74) and a part of the second contact device (76) of the contact spring (70) are arranged and secured against falling out in the direction of the exterior of the power semiconductor module (70) through a slot-like recess (84) for leading through the second contact device (76) of the contact spring (70), wherein this hollow body (80) has a snap-latch connection (82, 820, 360) with the housing (3) and a base body (86), wherein the base body has a stop means (88) on its side facing away from the inside of the power semiconductor module (1) for positioning in an abutment (38) of the recess (30) of the housing (3) and wherein the recess (30) has a second part recess (34) for leading through the first contact device (72) of the contact spring (70).

2. Power semiconductor module according to Claim 1,
wherein the base body (86) is formed cylindrically.

3. Power semiconductor module according to Claim 1,
wherein the snap-latch connection (82, 820, 360) is formed by a plurality of latches (82) of the hollow body (80), the latches (360) of which are formed by parts of the inside of the housing (3).

4. Power semiconductor module according to Claims 2 and 3,
wherein the recess (30) of the housing (3) has a plurality of further part recesses (36) for leading through the latches (82) and these further part recesses (36) are concentrically arranged around the second part recess (34).

5. Power semiconductor module according to Claim 1,
wherein the resilient section (74) of the contact spring (70) is constructed as a coil spring.

6. Power semiconductor module according to Claim 2,
wherein the first part recess (32) conically merges into the second part recess (34) and both are arranged flush with one another.

## Revendications

1. Module à semi-conducteurs de puissance (1) comprenant un boîtier (3), un substrat (5) disposé à l'intérieur du boîtier avec au moins une piste conductrice (54) métallique, et au moins un élément de raccordement (4, 7) allant de la piste conductrice (54) ou d'une surface de contact d'un composant à semi-conducteurs de puissance (60) disposé sur une piste conductrice vers l'extérieur,
le au moins un élément de raccordement (4, 7) étant conçu comme ressort de contact (70) avec un premier dispositif de contact (72) pour la mise en contact avec une piste conductrice du substrat ou une surface de contact du composant à semi-conducteurs de puissance, une partie (74) montée sur ressort et un second dispositif de contact (76) pour la liaison externe,
un corps creux (80) étant disposé dans un premier évidement partiel (32) d'un évidement (30) du boîtier (3), corps creux dans lequel à nouveau la partie (74) montée sur ressort et une partie du second dispositif de contact (76) du ressort de contact (70) sont disposées et sont protégées par un évidement (84) de type fente pour le passage du second dispositif de contact (76) du ressort de contact (70) contre une chute en direction de l'extérieur du module à semi-conducteurs de puissance (70), ce corps creux (80) présentant un assemblage à encliquetage et emboîtement (82, 820, 360) avec le boîtier (3) et un corps de base (86), le corps de base présentant sur son côté opposé à l'intérieur du module à semi-conducteurs de puissance (1) un moyen de butée (88) pour le positionnement dans un palier de butée (38) de l'évidement (30) du boîtier (3) et l'évidement (30) présentant un second évidement partiel (34) pour le passage du premier dispositif de contact (72) du ressort de contact (70).

2. Module à semi-conducteurs de puissance selon la revendication 1,
le corps de base (86) étant de configuration cylindrique.

3. Module à semi-conducteurs de puissance selon la revendication 1,
l'assemblage à encliquetage et emboîtement (82, 820, 360) étant formé par une pluralité d'ergots d'encliquetage (82) du corps creux (80), dont les paliers de butée (360) sont formés par des parties du côté intérieur du boîtier (3).

4. Module à semi-conducteurs de puissance selon les revendications 2 et 3,
l'évidement (30) du boîtier (3) présentant une pluralité d'autres évidements partiels (36) pour le passage des ergots d'encliquetage (82) et ces autres évidements partiels (36) étant disposés de façon concentrique autour du second évidement partiel (34).

5. Module à semi-conducteurs de puissance selon la revendication 1,
la partie (74) montée sur ressort du ressort de contact (70) étant conçue comme ressort cylindrique.

6. Module à semi-conducteurs de puissance selon la revendication 2,
le premier évidement partiel (32) en forme de cône passant à la place du second évidement partiel (34) et les deux évidements étant disposés en alignement l'un avec l'autre.
